# EUROPEAN PATENT APPLICATION

(11) **EP 0 730 296 A2**
(43) Date of publication of application: **04.09.1996**
(21) Application number: 96103217.4
(22) Date of filing: 01.03.1996
(51) Int. Cl.: H01L 23/495

(54) **Leadframe for plastic-encapsulated semiconductor device, semiconductor device using the same, and manufacturing method for the leadframe**

(30) Priority: 02.03.1995 JP 66661/95
(71) Applicant: DAI NIPPON PRINTING CO., LTD., Shinjuku-ku, Tokyo-to (JP)
(72) Inventor: Matsumura, Kenji, c/o Dai Nippon Printing Co, Ltd., Tokyo-to (JP)
(74) Representative: Müller-Boré & Partner Patentanwälte

(57) **Abstract**

Provided is a leadframe (1) of a copper alloy for plastic-encapsulated semiconductor device, in which a leadframe (1) material (copper alloy) can be prevented from delaminating from a molding plastic. The leadframe (1) comprises a film of the copper alloy, which is composed of copper and one or more metals selected from a group including silver, gold, platinum, and palladium, and is formed on the surface of the leadframe (1) material.

## Description

The present invention relates to a leadframe of a copper alloy for plastic-encapsulated semiconductor device, a semiconductor device using the same, and a manufacturing method for the leadframe, and more particularly, to prevention of delamination between a die pad portion or the like of the leadframe and a molding plastic.

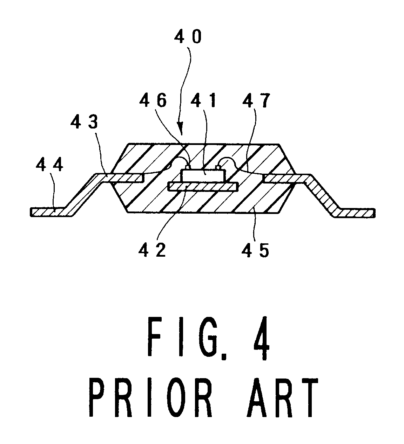

FIG. 4 shows a configuration of a conventional plastic-encapsulated semiconductor device (plastic leadframe package). In the semiconductor device 40, a semiconductor chip 41 is die-bonded to a leadframe which is formed of an iron or copper alloy, an electrode pad 46 of the semiconductor chip 41 and internal leads 43 of the leadframe are connected by means of wires (gold wires) 47, and the resulting structure is encapsulated with a plastic 45.

The leadframe is composed of a die pad portion 42 which carries the semiconductor chip 41 thereon, external leads 44 for electrical connection with an external circuit, and internal leads 43 integral with the external leads 44.

In modern semiconductor devices of this type, the operating speed and integration scale of semiconductor chips are highly improved, so that many of currently available copper alloy leadframes are excellent in radiation characteristics and the like.

In a plastic-encapsulated semiconductor device (plastic package), the adhesion between a molding plastic and the die pad portion or the like is an essential factor. In case delamination is caused between the plastic and the die pad portion, external water gets into the resulting void. In a solder reflowing process for mounting the semiconductor device on a board, the water may possibly expand with heat, thereby breaking the package.

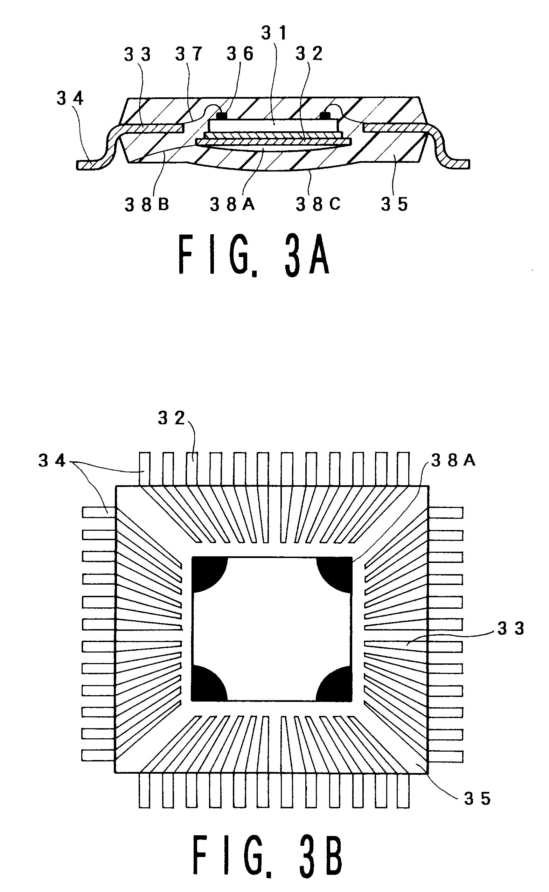

FIGS. 3A and 3B are a sectional view and a plan view, respectively, of an example of a plastic-encapsulated semiconductor device. In some cases, a void 38A may be formed over the surface of a die pad portion 32 opposite to that surface thereof which carries a semiconductor chip 31 thereon, possibly causing a crack 38B or blister 38C. In FIGS. 3A and 3B, numeral 33 denotes internal leads; 34, external leads; 35, molding plastic; 36, electrode; and 37, bonding wires.

In the case of the leadframe of the copper alloy which includes the die pad portion, in particular, delamination is liable to be caused between the molding plastic and the die pad portion.

Although the copper alloy can adhere to the molding plastic with a greater force than the iron alloy, it easily delaminates on account of poor adhesion between the leadframe material (copper alloy) and an oxide film formed by heating. Since the adhesive force between the iron alloy as the leadframe material and an oxide film formed by heating the iron alloy is so great that no delamination is caused between them. On the other hand, the adhesive force between the copper alloy and the oxide film is so small that delamination may be caused by a very small force in some cases.

An assembling stage for a plastic-encapsulated (plastic-package) semiconductor device includes many processes which involve heating. In a wire bonding process, in particular, the heating temperature generally exceeds 200°C. Thus, if the adhesion of an oxide film on the surface of the die pad portion opposite to that surface thereof which carries a semiconductor chip thereon is poor, in any of the processes which involve heat treatment, delamination is caused at the interface between the oxide film and the leadframe material (copper alloy) after plastic molding.

This is the mechanism of plastic delamination in the plastic-encapsulated semiconductor device which uses the copper alloy leadframe.

To cope with this, a silver film may be deposited to a thickness of tens of angstroms on the surface of the copper alloy leadframe by immersion.

This method is based on an effect that if silver on the surface diffuses into copper to form an alloy during heat treatment, the resulting oxide film of this alloy strongly adheres to the base material (leadframe material), and its force of adhesion to the plastic changes less than in the case of copper.

Although control of the silver film thickness is essential to this method, however, it is hard to control the thickness of the deposit formed by the immersion.

If the silver film is too thin, the adhesion of the oxide film cannot be improved satisfactorily. If the silver film is too thick, silver fails to diffuse fully into the interface between the leadframe (copper alloy) and the silver film and remains on the surface inevitably. The adhesion between silver on the surface and the molding plastic is so poor that delamination is caused between them.

Since the diffusion of silver varies depending on the heating conditions, moreover, the optimum thickness of the silver deposit varies according to the heating conditions for the assembling stage.

According to this method, therefore, it is difficult steadily to prevent delamination of the plastic in the plastic-encapsulated semiconductor device which is provided with the copper alloy leadframe. Also, this method is hardly applicable to mass production.

Thus, in the plastic-encapsulated semiconductor device using the copper alloy leadframe, the molding plastic is expected to be prevented from delaminating from the leadframe.

The object of the present invention is to provide a leadframe for plastic-encapsulated semiconductor device, a semiconductor device using the same, and a manufacturing method for the leadframe, in which an oxide film formed on the surface of the leadframe in any of processes of a semiconductor assembling stage which involve heat treatment cannot easily delaminate from a leadframe material (copper alloy), and the adhesion between the oxide film and a molding plastic is satisfactory. In a leadframe having a die pad portion, in particular, no delamination is caused on the surface of the die pad portion opposite to that surface thereof which carries a semiconductor chip thereon.

According to the present invention, there is provided a leadframe of a copper alloy for plastic-encapsulated semiconductor device, which comprises a film of the copper alloy composed of copper and one or more metals selected from a group including silver, gold, platinum, and palladium and formed on the surface of a leadframe material.

The copper alloy film contains 0.001 to 5.0% by weight of the one or more metals selected from the group including silver, gold, platinum, and palladium, as compared with copper.

The leadframe further comprises a die pad portion.

According to the invention, moreover, there is provided a plastic-encapsulated semiconductor device, which comprises the leadframe for plastic-encapsulated semiconductor device described above and encapsulated with a plastic.

According to the invention, furthermore, there is provided a manufacturing method for a leadframe of a copper alloy for plastic-encapsulated semiconductor device, which includes a film of the copper alloy composed of copper and one or more metals selected from a group including silver, gold, platinum, and palladium and formed on the surface of a leadframe material, comprises the step of forming a film of the copper alloy by plating the surface of the leadframe material in a copper plating bath containing one or more metallic compounds based on the metal or metals selected from the group including silver, gold, platinum, and palladium.

The copper plating bath contains 0.001 to 5.0% by weight of the one or more metals selected from the group including silver, gold, platinum, and palladium, as compared with copper.

Thus, according to the present invention, there may be provided a leadframe in which delamination between the leadframe material and the molding plastic can be prevented. In the leadframe having the die pad portion, in particular, delamination of the molding plastic from the die pad portion and cracking during a solder reflowing process can be prevented.

With use of this leadframe, the plastic-encapsulated semiconductor device according to the invention can be designed so that the incidence of delamination of the molding plastic from the leadframe material or cracking during the solder reflowing process can be restricted to an extremely low level. Thus, semiconductor devices of reliable quality can be mass-produced.

According to the leadframe manufacturing method of the invention, moreover, the entire process of manufacturing the leadframe can be adapted for practical mass production and integrated with the plating process for wire bonding.
FIGS. 1A and 1B show a leadframe according to an embodiment of the present invention, in which FIG. 1A is a sectional view, and FIG. 1B is a plan view;
FIG. 2 is a diagram showing the relationship between the composition of a copper-silver alloy film and adhesive force;
FIGS. 3A and 3B illustrate an adhesion failure and defect, in which FIG. 3A is a sectional view of the semiconductor device, and FIG. 3B is a plan view; and
FIG. 4 is a sectional view of a plastic-encapsulated semiconductor device.

A leadframe for plastic-encapsulated semiconductor device according to an embodiment of the present invention is designed so that it can be prevented from delaminating from a molding plastic. In a leadframe having a die pad portion, in particular, the molding plastic can be prevented from delaminating from the surface of the die pad portion opposite to that surface thereof which carries a semiconductor chip thereon.

More specifically, a film of a copper alloy composed of copper and one or more metals selected from a group including silver, gold, platinum, and palladium is formed on the surface of the die pad portion of the leadframe opposite to that surface which carries the semiconductor chip thereon. Thereupon, an oxide film is formed on the surface in a process, such as wire bonding, which is conducted in an assembling stage for the manufacture of a semiconductor device and involves heat treatment. The oxide film formed in this manner cannot easily delaminate from the material of the leadframe and adheres well to the molding plastic.

The copper alloy film contains 0.001 to 5.0% by weight of the one or more metals selected from the group including silver, gold, platinum, and palladium, as compared with copper. As the selected metal content is not lower than 0.001% by weight, the oxide film formed on the surface of the die pad portion or the like by the heat treatment cannot easily delaminate from the material (base material) of the leadframe. As the content is not higher than 5.0% by weight, moreover, the adhesive force between the oxide film and the molding plastic can be adjusted to values not lower than a predetermined value lest delamination be caused at the interface between the oxide film and the molding plastic.

The plastic-encapsulated semiconductor device according to the present embodiment uses the leadframe described above and is encapsulated with the plastic, so that delamination and cracking on the reverse side of the die pad portion are extremely rare. Thus, the device is suited for mass production.

A manufacturing method for manufacturing the leadframe for plastic-encapsulated semiconductor device according to the present embodiment comprises a process for shaping the die pad portion of the leadframe by etching or the like, and a process for forming the film of the copper alloy composed of copper and the one or more metals selected from the group including silver, gold, platinum, and palladium by means of plating the surface of the die pad portion opposite to that surface which carries the semiconductor chip thereon in a copper plating bath containing one or more soluble salts of the metal or metals selected from the group including silver, gold, platinum, and palladium. This method is a practical approach to mass production, in which the plating process and the film forming process constitute an integral production line.

The copper plating bath contains 0.001 to 5.0% by weight of the one or more metals selected from the group including silver, gold, platinum, and palladium, as compared with copper. Thus, a leadframe can be manufactured such that the oxide film, formed on the surface in the wire bonding process or the like which is conducted in the assembling stage for the manufacture of the semiconductor device and involves heat treatment, cannot easily delaminate from the material (copper alloy) of the leadframe, and that no delamination can be caused at the interface between the oxide film and the molding plastic.

### [Example]

An example of the leadframe for plastic-encapsulated semiconductor device according to the present invention will now be described with reference to the accompanying drawings.

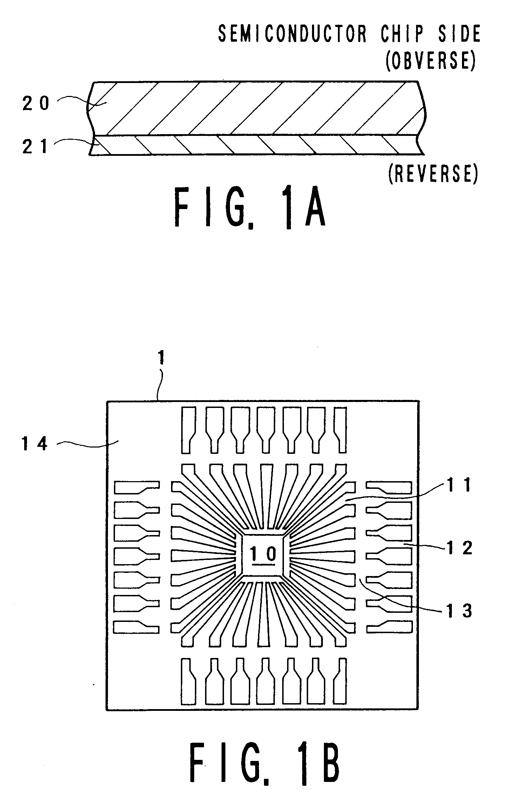

FIG. 1A is a sectional view of the die pad portion which constitutes the principal part of the leadframe, and FIG. 1B is a plan view of the whole leadframe.

In FIGS. 1A and 1B, numeral 1 denotes the leadframe; 10, die pad portion; 11, internal leads; 12, external leads; 13, dam bar; 14, frame portion; 20, leadframe material (copper alloy); and 21, copper-silver alloy film.

In the leadframe for plastic-encapsulated semiconductor device according to this example, the copper-silver alloy film 21, which is composed of copper and 0.1% by weight of silver as compared with copper, was formed to a thickness of 0.1 µm, directly on that surface of the leadframe material (copper alloy) 20 on the reverse side of the die pad portion 10 which is not expected to carry a semiconductor chip.

EFTEC 64T-1/2H from The Furukawa Co., Ltd. was used for the leadframe material 20. The leadframe material contains 0.35% of Cr, 0.25% of Sn, and 0.1% of Zn, all by weight, and impurities and copper for the remainder.

The copper-silver alloy film 21 was provided in order to improve the adhesion of an oxide film formed in the aforesaid manner and keep the adhesion between the oxide film and the molding plastic on the same level as in the case of the leadframe material. While the film composition was determined by the following test, the film need not always contain 0.1% by weight of silver as compared with copper.

In this example, the copper-silver alloy film 21 was 0.1 µm thick. It is necessary, however, only that the film 21 be 5,000 angstroms or more in thickness in order to improve the adhesion with the molding plastic and inhibit the influence of the leadframe material 20.

The composition of the copper-silver alloy film 21 was settled after examining the adhesive force between the leadframe material 20 and the molding plastic used in the example, in the following manner.

Films (0.1 µm thick) with various silver contents were formed on the surface of a plate material of the same composition as the leadframe material 20, and each of them was subjected to one hour of heat treatment at 150°C and 3 minutes of heat treatment at 280°C and encapsulated with the plastic in the following conditions. Thereafter, each film was subjected to 8 hours of post cure at 175°C, and the adhesive force after the heat treatment was measured by a shear test based on an autograph provided by Shimazu Corporation.

The molding plastic molding conditions are given as follows:
(1) Cold restoration of plastic: 20±1°C, 13% RH (relative humidity), 24 hours.
(2) Molding temperature: 23±1°C.
(3) Molding humidity: 32.5±2.5% RH.
(4) Transfer pressure: 2 tons.
(5) Transfer temperature: 175°C.
(6) Molding time: 80 seconds.
(7) Measuring conditions:
   Room temperature for measurement: 20±1°C.
   Humidity: 30±2.5% RH.

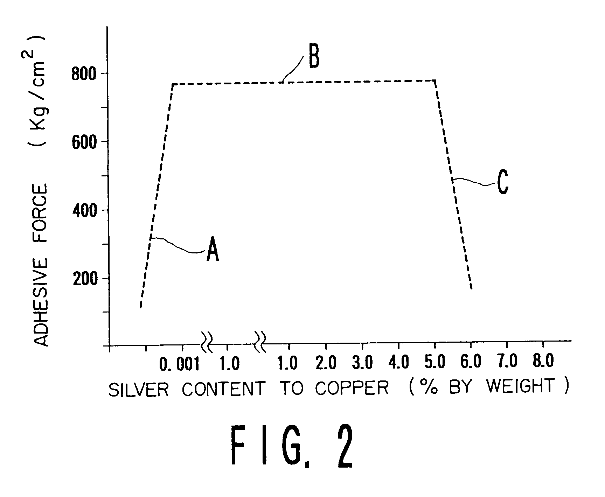

FIG. 2 shows the results of measurement of the adhesive force.

In the range (straight line portion A) where the silver content compared with copper was about 0.001 or less by weight, as seen from FIG. 2, the lower the silver content, the smaller the adhesive force was.

In the range (straight line portion B) where the silver content compared with copper was 0.001 to 5% by weight, the adhesive force was substantially on the same level as in the case of the unheated leadframe material (copper alloy).

In the range (straight line portion C) where the silver content compared with copper was 5% or more, the adhesive force was reduced as the silver content increased.

In order to prevent the leadframe and the molding plastic from delaminating from each other, therefore, the silver content of the copper-silver alloy film compared with copper should only range from about 0.001 to 5% by weight, as shown in FIG. 2.

In the case (straight line portion A) where the silver content compared with copper was about 0.001% or less by weight, as shown in Fig. 2, delamination was caused between the leadframe material (copper alloy) and the oxide film. In the case (straight line portion C) where the silver content compared with copper was 5% or more, delamination was caused at the interface between the oxide film and the plastic.

The copper-silver alloy film 21 may be replaced with a material which contains copper and precious metals, such as gold, platinum, palladium, etc.

The preferred precious metal content is estimated to be basically the same as in the case where the material contains silver.

Although EFTEC 64T-1/2H from The Furukawa Co., Ltd. was used for the leadframe material 20 in the example described above, a copper alloy may alternatively be used as a conventional leadframe material with the same result.

In the aforesaid test, the copper-silver alloy film was formed in a plating bath of the following composition with the cathode current density of 50 A/dm² at 40°C.

Plating bath composition:
Cuprous cyanide: 30 g/l.
Potassium cyanide: 50 g/l.
Potassium hydroxide: 5 g/l.
Rochelle salt: 20 g/l.
Silver potassium cyanide: 0.4 mg/l to 2 g/l.

The silver content of the copper-silver alloy film was changed according to the silver potassium cyanide concentration.

A semiconductor device was manufactured by plastic molding by using the leadframe of the example, as shown in FIG. 4. A monitor inspection using an ultrasonic inspection machine (scanner-type ultrasonic image flaw detector, MI-SCOPE 10, from Hitachi Construction Machinery Co., Ltd.) revealed hardly any delamination on the side (reverse side) without the semiconductor chip of the die pad portion thereon. No cracking was observed during the solder reflowing process either.

While the presently preferred embodiment of the present invention has been shown and described, it is to be understood that this disclosure is for the purpose of illustration and that various changes and modifications may be made without departing from the scope of the invention as set forth in the appended claims.

## Claims

1. A leadframe of a copper alloy for plastic-encapsulated semiconductor device, comprising a film of the copper alloy formed on the surface of a leadframe (1) material,
characterized in that said film of the copper alloy is composed of copper and one or more metals selected from a group including silver, gold, platinum, and palladium.

2. The leadframe for plastic-encapsulated semiconductor device according to claim 1, characterized in that said copper alloy film contains 0.001 to 5.0% by weight of the one or more metals selected from the group including silver, gold, platinum, and palladium, as compared with copper.

3. The leadframe for plastic-encapsulated semiconductor device according to claim 1 or 2, characterized by further comprising a die pad portion (10).

4. A plastic-encapsulated semiconductor device, characterized by comprising the leadframe for plastic-encapsulated semiconductor device according to one or more of claims 1 to 3 and encapsulated with a plastic.

5. A manufacturing method for a leadframe of a copper alloy for plastic-encapsulated semiconductor device, which includes a film of the copper alloy composed of copper and one or more metals selected from a group including silver, gold, platinum, and palladium and formed on the surface of a leadframe (1) material, characterized by comprising the step of:
forming a film of the copper alloy by plating the surface of the leadframe (1) material in a copper plating bath containing one or more metallic compounds based on the metal or metals selected from the group including silver, gold, platinum, and palladium.

6. The manufacturing method for a leadframe for plastic-encapsulated semiconductor device according to claim 5, characterized in that said copper plating bath contains 0.001 to 5.0% by weight of the one or more metals selected from the group including silver, gold, platinum, and palladium, as compared with copper.
